# EUROPEAN PATENT SPECIFICATION

(11) **EP 2 838 120 B1**
(45) Date of publication and mention of the grant of the patent: **23.03.2016**
(21) Application number: 13180134.2
(22) Date of filing: 12.08.2013
(51) Int. Cl.: H01L 31/028, H01L 31/0352, H01L 31/068, H01L 31/103, H01L 31/18, H01L 21/20

(54) **Graded band gap pn homojunction formation method in silicon**
Verfahren zur Herstellung eines Silizium pn Homoübergangs mit graduellem Bandabstand
Procédé de formation d'une homojonction pn à base de silicium avec bande interdite graduée

(43) Date of publication of application: 18.02.2015
(73) Proprietor: Rigas Tehniska Universitate, 1658 Riga (LV)
(72) Inventor: Medvids, Arturs, LV-1002 Riga (LV); Onufrijevs, Pavels, LV-1083 Riga (LV); Dauksta, Edvins, LV-1082 Riga (LV); Mezinskis, Gundars, LV-2137 Rigas rajons (LV)
(74) Representative: Vitina, Maruta

(56) References cited:
- CN-A- 101 315 957
- LV-B- 13 968
- US-A- 4 116 719
- US-A- 4 147 563
- US-A- 4 181 538
- US-A- 4 322 253
- US-B2- 7 253 491
- Y.MADA AND N. INOUE: "pn junction fromation using laser induced donors in silicon", APPLIED PHYSICS LETTERS, vol. 48, 5 May 1986 (1986-05-05), pages 1205-1207, XP002718407, DOI: 10.1063/1.96982

## Description

The invention relates to technical physics and can be used in the production of light-absorbing and light-emitting semiconductor devices.

A method for formation of a p-n homojunction is known [Patent US7253491], which includes formation of an ultra thin Si layer with the dopant, which type is opposite to the base type, to achieve the photovoltaic conversion of light in the spectral region from 100 to 1100 nm due to the quantum confinement effect. However, the main disadvantages of the method for formation of a p-n homojunction are the high processing temperatures (up to 1400°C) and the need to enter additional alloying atoms.

A method for formation of a p-n homojunction is known [Patent LV13968B] where the p-n homojunction is formed on a germanium surface by laser irradiation. To form the p-n homojunction, the monocrystalline i-type conductivity germanium samples are used for tests with resistivity p = 45 Ω•cm at room temperature. Germanium surface is irradiated by Nd: YAG laser radiation with the following parameters: wavelength 1064 nm, pulse length 15 ns, beam diameter 3 mm. In the known method a high temperature gradient appears during processing, as a result of which interstitial atoms and vacancies are formed on the surface of the semiconductor and redistributed under thermo gradient effect: the vacancies drift in to the volume, and the interstitial atoms - to the irradiated surface. According to James and Lark-Gorovitz theory [Atomic Diffusion in Semiconductors. D. Shaw, Ed., Plenum Press London and New York, 1973, pp.260-261, ISBN-13: 978-1-4615-8638-8] the vacancies are positively charged, while the interstitial atoms are negative, so a p-n junction is formed. In this case, the p-n homojunction is formed in the depth of more than 200 nm. Since germanium is an indirect semiconductor, the formed p-n homojunction absorbs and emits visible light ineffectively. In addition, it is impossible to form a graded band gap structure by this method.

A method for formation of a p-n homojunction is known [Y. Mada and N. Inoue, pn junction formation using laser induced donors in silicon: Appl. Phys. Lett. 48, 1205 (1986), doi: 10.1063/1.96982] comprising annealing p-type silicon with a laser beam having the following parameters: wavelength of 532 nm, pulse repetition frequency of 4kHz, pulse duration of 50 ns, pulse energy density of 1.75 J/cm2, the beam diameter of 80 µm. Irradiation is carried out in scanning mode at the speed of 10 mm/s. In the known method the treatment by laser causes melting of the silicon surface layer and formation of electrically active defects, by which the formation of the p-n junction due to irradiation by laser radiation is explained.

The p-n homojunction is formed 400 nm deep. Since silicon is an indirect semiconductor, the formed p-n homojunction absorbs and emits visible light ineffectively. In addition, it is impossible to form a graded band gap structure by this method.

It is known that the quantum confinement effect takes place in a silicon layer with the thickness equal to or less than the De Broglie wavelength of electron for silicon, namely, 26 nm [Sergey V. Gaponenko, Introduction to Nanophotonics, Cambridge University Press, April 08, 2010, ISBN: 978-0-521-76375-2].

A method of making selective crystalline silicon regions containing entrapped hydrogen by laser treatment is disclosed in US 4 322 253.

The technical problem solved by the present invention is to develop a simple method for formation of a graded band gap p-n homojunction in silicon, which effectively absorbs and emits light in a broad spectral range, including visible light. In a method for formation of a graded band gap p-n homojunction in silicon comprising a step of formation of a p-n junction in a p-type conductivity silicon monocrystal having a resistivity of 1 to 10 Ω•cm, surface roughness of the monocrystal being less than 1.6 nm, by irradiating the surface with a pulsed laser, according to the invention, the surface of the p-type conductivity silicon monocrystal is irradiated by laser radiation with an absorption coefficient in silicon no less than 10⁶ cm⁻¹, the laser radiation doses being between 30 and 750 mJ/cm², and the length of the pulses being between 1 and 10 ns, to form a graded band gap p-n homojunction with a thickness of the n-type layer equal to or less than 26 nm on the surface layer of the silicon monocrystal.

Laser parameters were selected experimentally to ensure the formation of the p-n homojunction with the n-type conductivity layer thickness equal to or less than 26 nm (the wavelength of electron De Broglie for silicon). For irradiation of p-type conductivity silicon monocrystal surface only the laser radiation with an absorption coefficient not less than 10⁶ cm⁻¹ can be used to provide laser radiation penetration depth not exceeding 26 nm. Such lasers are, for example, Nd: YAG, XeF, Ruby, Ar²⁺, N₂, Ne⁺, He-Cd, XeCl, KrF, HeAg⁺, KrCl, ArF, F₂ lasers. If the laser radiation dose is greater than 750 mJ/cm², silicon starts to melt. If the laser radiation dose is less than 30 mJ/cm², the drift speed of the interstitial atoms and vacancies is insufficient to form a p-n junction. Once a n-type conductivity layer thickness is equal to or less than 26 nm, the quantum confinement effect takes place in this layer. As a result, the silicon band gap width increases with the formation of the graded band gap p-n homojunction between the p-type conductivity silicon monocrystal and the irradiated n-type conductivity layer. In addition, silicon transits from an indirect band gap to a direct band gap semiconductor. Consequently, the formed graded band gap p-n homojunction effectively absorbs and emits light in a broad spectral range, including visible light. Its formation method is technologically simple.

The p-type conductivity silicon monocrystal can be irradiated by laser radiation in the presence of air, if before the irradiation the silicon dioxide coating with the thickness not more than 100 nm is formed on its surface. The silicon dioxide coating protects the surface of the silicon monocrystal from the environment, but allows the laser radiation to pass through.

Explanation of the invention drawings, showing:
Fig.1. - current-voltage characteristic of the graded band gap p-n homojunction formed in the silicon monocrystal;
Fig.2. - photoluminescence spectrum of the graded band gap p-n homojunction structure formed in the silicon monocrystal;
Fig.3. - the dependence of the band gap width of the graded band gap p-n homojunction formed in the silicon monocrystal on the distance to the surface of the silicon monocrystal (depth).

The proposed method for formation of a graded band gap p-n homojunction in silicon is performed as follows.

The graded band gap p-n homojunction is formed in the p-type conductivity silicon monocrystal with resistivity 7.5 Ω•cm, surface roughness <1.6 nm and silicon dioxide coating thickness 100 nm. The monocrystal surface coated with silicon dioxide in the presence of air (at t° = 20°C and atmospheric pressure) was irradiated by a pulse Nd: YAG laser radiation with a wavelength 266 nm (for such laser radiation the absorption coefficient in silicon is 2•10⁶ cm⁻¹), laser radiation dose 450 mJ/cm², pulse duration 3 ns and pulse repetition rate 10 Hz. The laser beam diameter is 5 mm, and the sample is irradiated by point-to-point method with a laser beam perpendicular to the surface by 10 laser pulses.

The electrical properties of the graded band gap p-n homojunction are determined by the current-voltage characteristic measurement method, before the measurement the silicon dioxide layer was removed and aluminum electrical contact was formed, but on the opposite side the second aluminum electrical contact was formed.

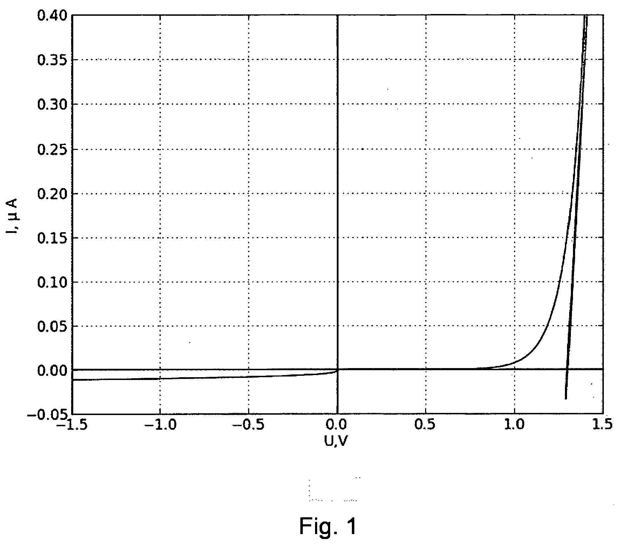

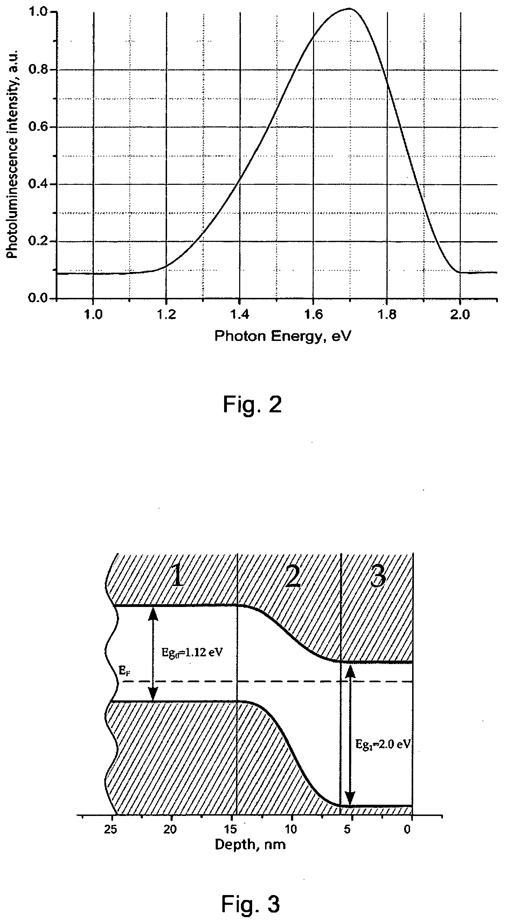

The current-voltage characteristic of the graded band gap p-n homojunction formed in silicon monocrystal by Nd:YAG laser is shown on Fig. 1. The current-voltage characteristic shows that the p-n junction is formed in the silicon monocrystal and it is possible to determine the barrier height Φ = 1.3 eV. The value of the barrier height is not typical of the silicon monocrystal and it can be explained by quantum confinement effect in the formed n-type silicon layer, consequently at the surface of the silicon monocrystal the graded band gap p-n homojunction with the n-type layer thickness equal to or less than 26 nm, namely, 10 nm is formed. Fig. 2 shows the photoluminescence spectrum of the graded band gap p-n homojunction structure formed in silicon monocrystal, excited by an argon laser with a wavelength of 514.5 nm. The shape of the spectrum shown on Fig. 2 is asymmetric and monotonely increasing till the peak of photoluminescence spectrum at 1.7 eV. Such shape of a photoluminescence spectrum is typical of a graded band gap structure. The graded band gap p-n homojunction formed in the silicon monocrystal effectively absorbs and emits light in a wide spectral range (from 1.12 and 2.0 eV), including visible light. In this graded band gap structure, irradiating it by photons with energy till 2 eV, no hot electrons, which negatively affect light-absorption and light-emission in semiconductor devices, are formed. In addition, due to the expansion of the band gap, the voltage generated by light-absorption semiconductor devices such as solar cells, is increased. Fig. 3 shows a schematic drawing of the dependence of the band gap width of the graded band gap p-n homojunction formed in the silicon monocrystal on the distance to the surface of the silicon monocrystal. Left hand side of the drawing shows the part (1) of non-irradiated p-type conductivity silicon monocrystal with band gap width 1.12 eV. Right hand side of the drawing shows the part (3) of the n-type conductivity layer, which is formed in silicon monocrystal by Nd:YAG laser irradiation, with band gap width 2.0 eV and thickness less than 26 nm and in which the quantum confinement effect takes place. Between the part (1) of the non-irradiated p-type conductivity silicon monocrystal and the part (3) of the formed n-type conductivity layer there is the depletion region (2) of p-n junction with a variable width of the band gap - the graded band gap.

## Claims

1. A method for formation of a graded band gap p-n homojunction in silicon comprising a step of formation of a p-n junction in a p-type conductivity silicon monocrystal having a resistivity of 1 to 10 Ω•cm, surface roughness of the monocrystal being less than 1.6 nm, by irradiating the surface with a pulsed laser,
**characterized in that**
the surface of the p-type conductivity silicon monocrystal is irradiated by laser radiation with an absorption coefficient in silicon no less than 10⁶ cm⁻¹, the laser radiation doses being between 30 and 750 mJ/cm², and the length of the pulses being between 1 and 10 ns, to form a graded band gap p-n homojunction with a thickness of the n-type layer equal to or less than 26 nm on the surface layer of the silicon monocrystal.

2. The method according to claim 1, **characterized in that** before the laser irradiation of the surface of the p-type conductivity silicon monocrystal it is coated with a layer of silicon dioxide with thickness no more than 100 nm, and the laser irradiation is carried out in the presence of air.

## Patentansprüche

1. Verfahren zur Herstellung eines p-n Homoübergangs mit graduellem Bandabstand in Silizium umfassend die Bildung eines p-n Übergangs in einem p-Typ-Silizium-Einkristall mit spezifischem Widerstand 1-10 Ω•cm und mit Oberfläche Rauheit weniger als 1,6 nm durch Bestrahlung mit gepulstem Laser,
**dadurch gekennzeichnet, dass**
die Oberfläche des p-Typ-Silizium-Einkristalls mit Laserstrahlung mit Absorptionskoeffizient in Silizium nicht weniger als 10⁶ cm⁻¹, mit Laser-Strahlendosen zwishen 30 and 750 mJ/cm² und Länge der Laser-Impulse zwishen 1 und 10 ns bestrahlt wird, um einen p-n Homoübergang mit graduellem Bandabstand in Silizium mit Dicke der n-Typ-Schicht gleich oder weniger als 26 nm auf der Oberflächenschicht des Silizium-Einkristalls zu bilden.

2. Verfahren nach Anspruch 1., **dadurch gekennzeichnet, dass** die Oberfläche des p-Typ-Silizium-Einkristalls vor der Laserbestrahlung mit einer Silizium-Dioxide-Schicht mit Dicke nicht mehr als 100 nm beschichtet wird und die Laserbestrahlung in Gegenwart von Luft durchgeführt wird.

## Revendications

1. Procédé de formation d'une bande à gradient homojonction p-n écart en silicium comprenant une étape de formation d'une jonction p-n dans un monocristal de silicium de conductivité de type-p ayant une résistivité de 1 à 10 Ω•cm, la rugosité de surface du monocristal étant inférieure à 1,6 nm, en irradiant la surface avec un laser pulsé, **caractérisé en ce que** la surface du type-p de conductivité monocristal de silicium est irradié par un rayonnement laser avec un coefficient d'absorption dans le silicium au moins 10⁶ cm⁻¹, les doses de rayonnement laser étant comprise entre 30 et 750 mJ/cm², et la durée des impulsions étant comprise entre 1 et 10 ns, pour former un gradient de bande interdite pn homojonction avec une épaisseur de la couche de type-n de moins de ou égale à 26 nm sur la couche de surface du monocristal de silicium.

2. Procédé selon la revendication 1, **caractérisé en ce qu'**avant l'irradiation par laser de la surface du type-p monocristallin de conductivité de silicium elle est revêtue d'une couche de dioxyde de silicium avec une épaisseur ne dépassant pas 100 nm, et l'irradiation par laser est effectuée en la présence d'air.
